(19) Europäisches Patentamt
European Patent Office
Office européen des brevets

(11) **EP 2 102 987 B1**

(12) **EUROPÄISCHE PATENTSCHRIFT**

(45) Veröffentlichungstag und Bekanntmachung des Hinweises auf die Patenterteilung:
**05.04.2017 Patentblatt 2017/14**

(51) Int Cl.:
***H03M 3/04*** *(2006.01)*

(21) Anmeldenummer: **07821237.0**

(22) Anmeldetag: **12.10.2007**

(86) Internationale Anmeldenummer:
**PCT/EP2007/060870**

(87) Internationale Veröffentlichungsnummer:
**WO 2008/068094 (12.06.2008 Gazette 2008/24)**

(54) **BANDPASS SIGMA-DELTA-ANALOG/DIGITAL-WANDLER ZUR WANDLUNG EINES ZF-SIGNALS**

BANDPASS SIGMA-DELTA ANALOGUE/DIGITAL CONVERTER FOR CONVERTING AN IF SIGNAL

CONVERTISSEUR ANALOGIQUE-NUMÉRIQUE À BANDE PASSANTE SIGMA-DELTA POUR LA CONVERTION D'UN SIGNAL ZF

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **08.12.2006 DE 102006057926**

(43) Veröffentlichungstag der Anmeldung:
**23.09.2009 Patentblatt 2009/39**

(73) Patentinhaber: **Robert Bosch GmbH**
**70442 Stuttgart (DE)**

(72) Erfinder:
• **MAEDER, Heinz**
**8570 Weinfelden (CH)**
• **LEHR, Carsten**
**30163 Hannover (DE)**
• **NYENHUIS, Detlev**
**31079 Sibbesse (DE)**

(56) Entgegenhaltungen:
**US-A1- 2005 134 492**

• **UENO T ET AL: "A FOURTH-ORDER BANDPASS DELTA-SIGMA MODULATOR USING SECOND-ORDER BANDPASS NOISE-SHAPING DYNAMIC ELEMENT MATCHING" IEEE JOURNAL OF SOLID-STATE CIRCUITS, IEEE SERVICE CENTER, PISCATAWAY, NJ, US, Bd. 37, Nr. 7, Juli 2002 (2002-07), Seiten 809-816, XP001221302 ISSN: 0018-9200**

EP 2 102 987 B1

**Beschreibung**

Die Erfindung betrifft im Allgemeinen einen ZF-Bandpass-Sigma-Delta-Analog/Digital-Wandler (A/D-Wandler).

Die gegenwärtig in Serienfertigung hergestellten digitalen Autoradio-Erzeugnisse wandeln die Zwischenfrequenz (ZF) mit Hilfe eines Bandpass-Sigma-Delta-Modulators (BPSDM) um. Der BPSDM tastet die Zwischenfrequenz ZF bei $f_s$ = 14,25 MHz ab. Die Resonanzfrequenz ist dabei eingestellt auf $f_{Res}$ = $f_s$/4 = 3,5625 MHz. Die Abtastoperation bewirkt, dass die Zwischenfrequenz ZF auf die Resonanzfrequenz bei den ungeraden Oberschwingungen der Resonanzfrequenz von fR gefaltet wird. Die dritte Oberschwingung von 10,6875 MHz entspricht der ZF des Empfängers.

Die US 5.442.353 beschreibt Bandpass-Sigma-Delta-Analog/Digital-Wandler, der aus einen ersten Bandpass-Sigma-Delta-Modulator 4. Ordnung und einem zweiten Bandpass-Sigma-Delta-Modulator 2. Ordnung besteht, wobei der zweite Wandlers das Signal des ersten Wandlers verarbeitet. Die digitalen Signale des ersten und des zweiten Wandlers werden mit einem digitalen Filter derart verknüpft, dass das Quantisierungs-Rauschen des ersten Wandlers entfällt.

Die US 2005/0134492 A1 offenbart einen Sigma-Delta-Digital/Analog Wandler und eine diesbezügliches Verfahren.

Die GB 2364188 beschreibt einen Mehrweg-Sigma-Delta-Modulator wobei jeder separate Signalpfad aus zwei Bandpass-Sigma-Delta-Modulatoren von 4. und 2. Ordnung und einem digitalen Filter besteht.

Die WO 00/01074 offenbart einen zeitkontinuierlichen Sigma-Delta-Modulator mit dem bekannten Vorteil, dass durch das zeitkontinuierliche Schleifenfilter zur Unterdrückung der Störbänder beiträgt, die durch Faltung ins Signalband gelangen können.

Der mit einer Abtastfrequenz von $f_s$ = 14,25 MHz getaktete Bandpass-Sigma-Delta-Modulator hat einige Schwächen; diese sind:

a) Oberschwingungen des Abtasttaktsignals fallen in das europäische und japanische Frequenzmodulations-(FM)-Band und desensibilisieren den Empfänger bei den folgenden Frequenzen: 5. Oberton (OT) von $f_s$ bei 85,50 MHz (Japan) und 7. Oberton (OT) von $f_s$ bei 99,75 MHz (Europa).

b) Der Empfänger muss eine adäquate Unterdrückung benachbarter Kanäle bei einer ZF = LO $\pm$ $f_{Res}$ mit Hilfe des abgestimmten Vorkreises und des keramischen Bandpassfilters gewährleisten. Vorausgesetzt, dass der BPSDM in seiner Grundschwingungsform mit $f_{Res}$ = ZF betrieben wird, kann die erforderliche Unterdrückung so weit abgeschwächt werden, dass Sie durch nur einen abgestimmten Vorkreis erreicht werden kann.

Eine Aufgabe der Erfindung ist die Milderung der Nachteile herkömmlicher ZF-Bandpass-Sigma-Delta-Analog-Digital-Wandler. Um die erwähnten Nachteile zu überwinden, wurde ein Bandpass-Sigma-Delta-Analog-Digital-Wandler entsprechend Anspruch 1 beschaffen.

Dabei kann es vorteilhaft sein, wenn der erste und der zweite Bandpass-Filter mit geschalteten Kapazitäten implementiert sind, so dass das Quantisierungsrauschen bei einer bevorzugten Abtastfrequenz von insbesondere 37.05MHz für die bevorzugte Zwischenfrequenz (ZF) von 10,700 MHz ein Minimum aufweist.

Weiterhin kann es vorteilhaft sein, wenn die Frequenz des Rauschminimum im Wesentlichen durch ganzzahlige Kapazitätsverhältnisse bestimmt wird. Dadurch kann in vorteilhafter Weise die Bestimmung der Frequenz des Rauschminimums ein Frequenzabgleich hinfällig werden.

Bei einem weiteren Ausführungsbeispiel der Erfindung ist es vorteilhaft, wenn das erste Bandpass-Filter durch einen LC-Schwingkreis mit integriertem Frequenzabgleich gebildet ist und/oder das zweite Bandpass-Filter mit geschalteten Kapazitäten implementiert ist.

Ebenso ist es vorteilhaft, wenn mittels einer Verstärkerschaltung ein variabler negativer Widerstand parallel zum LC-Schwingkreis vorgesehen wird der den LC-Schwingkreis zum Frequenzabgleich zum Schwingen anregt. Dabei ist es auch vorteilhaft, wenn der Widerstand weiterhin zur Anhebung der Kreisgüte des LC-Schwingkreis verwendbar ist.

Dabei ist es zweckmäßig, wenn der Bandpass-Sigma-Delta-Analog-Digital-Wandler bei einer Abtastfrequenz von 37.05MHz betrieben wird, so dass die Obertöne der Taktfrequenz vorteilhaft außerhalb des europäischen als auch des japanischen FM-Bandes zu liegen kommen. Die Wahl der Zwischenfrequenz von ZF 10,700 MHz wurde beibehalten, um die vorhandenen preiswerten externen ZF-Filterkomponenten verwenden zu können.

Die oben erwähnten und weitere Merkmale und Vorteile der Erfindung werden aus der nachfolgenden Beschreibung einer beispielhaften Ausführungsform der Erfindung unter Bezugnahme auf die beigefügten Zeichnungen offensichtlich. Es zeigt:

Fig. 1    ein Blockschaltbild eines erfindungsgemäßen Bandpass-Sigma-Delta-Modulators;

Fig. 2    ein Blockschaltbild eines erfindungsgemäßen Bandpass-Sigma-Delta-Modulators;

Fig. 3          ein Diagramm;

Fig. 4          ein Blockschaltbild eines erfindungsgemäßen Bandpass-Sigma-Delta-Modulators;

Fig. 5          ein Diagramm;

Fig. 6          ein Blockschaltbild eines erfindungsgemäßen Bandpass-Sigma-Delta-Modulators;

Fig. 7          ein Blockschaltbild;

Fig. 8          ein Blockschaltbild;

Fig. 9          ein Blockschaltbild eines erfindungsgemäßen Bandpass-Sigma-Delta-Modulators; und

Fig. 10         ein Diagramm.

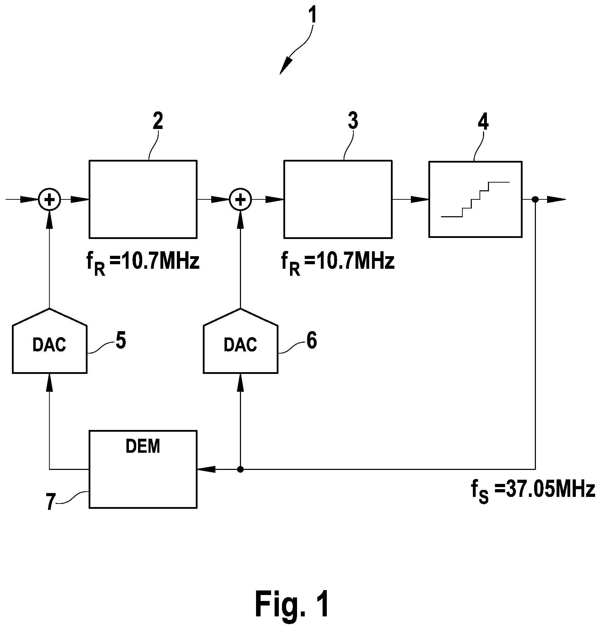

Die Figur 1 zeigt einen allgemeinen Aufbau eines Bandpass-Sigma-Delta-Modulators 1 (BPSDM). Der Aufbau des Bandpass-Sigma-Delta-Modulators 1 besteht aus zwei in Kaskade geschalteten Bandpassfiltern zweiter Ordnung 2,3 mit Rückkopplung vom Multi-bit Quantisierer 4 zum ersten Filter über D/A Umsetzer 5 (D/A-Converter oder DAC) und zum zweiten Filter über D/A Umsetzer 6. Der BPSDM 1 ist daher ein Modulator vierter Ordnung. Der Quantisierer 4 wird vom zweiten Filter 3 angesteuert. Der Quantisierer 4 und die D/A Umsetzer 5, 6 werden vorteilhaft als Multi-bit Umsetzer ausgeführt, um das Quantisierungsrauschen des Modulators möglichst weiter zu verringern. Die Linearität des D/A Umsetzers 6 zum ersten Filter 2 wird durch Dynamic-Element-Matching-Stuermodul (DEM) 7 mit Bandpass-Rauschformung verbessert. Dank des verwendeten Rauschformungsalgorithmus zweiter Ordnung wird das Quantisierungsrauschen bei der Zwischenfrequenz minimiert, welches sich aus Linearitätsfehlern des D/A-Wandlers ergibt.

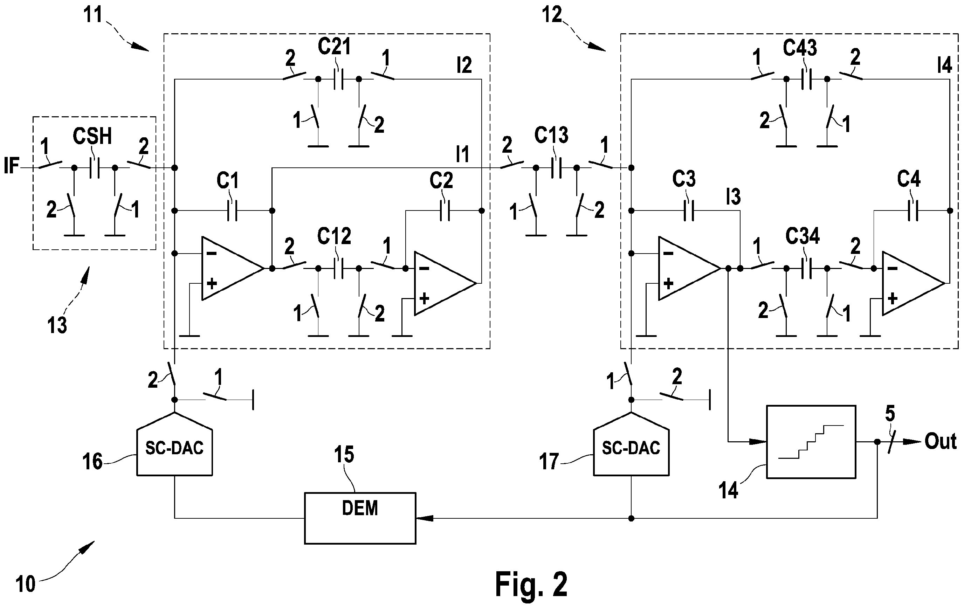

Die Figur 2 zeigt die bevorzugte Ausführung eines Bandpass-Sigma-Delta Modulators (BPSDM) 10 mit geschalteten Kondensatoren. Der Einfachheit halber wurde die zur Implementierung vorgesehene symmetrische Schaltung durch ein äquivalentes unsymmetrisches Schaltbild ersetzt. Die beiden Bandpass-Filter 11,12 sind dabei als SC-Schwingkreise ausgeführt. Der erste SC-Schwingkreis 11 besteht aus den beiden Integratoren I1 und I2 die durch die Kondensatoren C1 und C2, und den dazugehörenden Verstärker gebildet werden, sowie den geschalteten Kapazitäten C12 und C21. Der zweite SC-Schwingkreis 12 ist ähnlich aufgebaut wie der erste SC-Schwingkreis und besteht aus den beiden Integratoren 13 und 14 die durch die Kapazitäten C3 und C4, und den dazugehörenden Verstärker gebildet werden, sowie den geschalteten Kapazitäten C34 und C43. Die beiden SC-Schwingkreise unterscheiden sich im Wesentlichen nur durch die verwendeten Kapazitätswerte, sowie die Dimensionierungen der Schalter und Verstärker.

Die Zwischenfrequenz ZF wird durch das Abtast- und Halteglied 13 abgetastet. Vom Ausgangsstrom des Abtast- und Halteglieds 13 wird der Ausgangsstrom des D/A-Wandlers 17 subtrahiert und der Differenzstrom am Eingang des ersten Schwingkreises 11 eingespeist. Die Kopplung vom ersten Schwingkreis 11 an den zweiten Schwingkreis 12 erfolgt mit Hilfe des geschalteten Kondensators C13.

Der Quantisierer 14 wird vom Schwingkreis S2 angesteuert. Die erste Rückkopplung vom D/A Umsetzer 16 zum ersten SC Schwingkreis wird über das DEM Steuermodul 15 geführt, womit durch Dynamische-Elemente-Paarung (DEM) mit Rauschformung zweiter Ordnung das durch Paarungsfehler im D/A Umsetzer 16 verursachte Quantisierungsrauschen im Nutzband verringert wird.

Die zweite Rückkopplung 17 an den zweiten SC-Schwingkreis erfolgt durch die Einspeisung des Ausgangsstroms des D/A Umsetzers 14 zum Eingang des zweiten SC Schwingkreises. Der Quantisierer 14 als auch die beiden D/A Umsetzer weisen eine Auflösung von 17 Stufen auf. Die beiden D/A Umsetzer 16 und 17 wurde mit geschalteten Kapazitäten ausgeführt (SC-DAC).

Der zweite D/A Wandler 17 könnte als Alternative auch vom Steuermodul 15 angesteuert werden, mit dem Vorteil, die Linearitätsfehler auch im zweiten D/A Wandler zu reduzieren. Untersuchungen haben jedoch ergeben, dass die Linearitätsfehler am zweiten D/A Wandler 17 einen wesentlich (ca. 10x) kleineren Einfluss haben wie die Linearitätsfehler am ersten D/A Wandler 16. Aus diesem Grund kann die Linearisierung des zweiten D/A Wandlers auch vermieden werden. Der Vorteil der Linearisierung durch das DEM Steuermodul ist an dieser Stelle dem erhöhten Aufwand, bedingt durch das aggressivere Timing, entgegenzustellen.

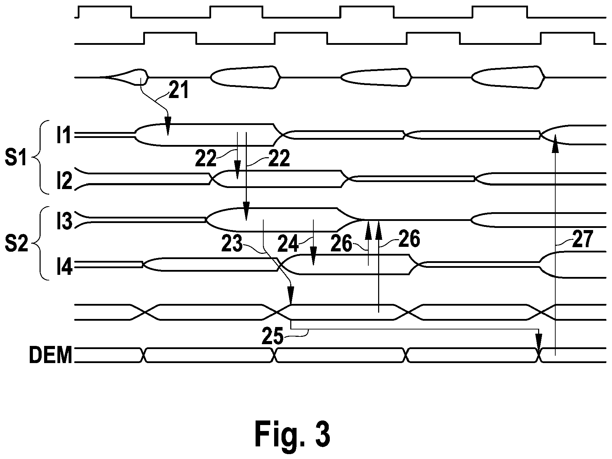

Der zeitliche Ablauf des BPSDM ist in Figur 3 gezeigt. Während das Taktsignal P1 hoch ist, befindet sich das Abtast- und Halteglied im Abtast-Modus und lädt, unter Bezugnahme auf Figur 2, den Kondensator CSH des Abtast- und Halteglieds 13 auf den momentanwert des Eingangssignals IF. Bei abfallender Taktimpulsflanke von P1 wird der Kondensator CSH vom Eingang getrennt und behält seine Ladung, die der Spannung über CSH im Moment der Abtastung entspricht. Die abgetastete Ladung wird dann während des folgenden Taktsignals P2 gemäß Bezugszeichen 21 in Figur 3 an den ersten Integrator I1 des ersten SC-Schwingkreises übertragen. Die weiteren Ladungsübertragungen 22 bis 27 sind ebenfalls in Figur 3 dargestellt. Die in Figur 3 dargestellten Spannungsverläufe des Abtast- und Halteglieds und der vier Integratoren veranschaulichen die Spannungsverläufe an deren komplementären Ausgängen.

Der Quantisierer umfasst einen A/D Wandler, der das analoge Eingangssignal in ein 17-stufiges digitales Signal umsetzt. Zur A/D Wandlung werden 16 Komparatoren verwendet. Die zustandsgesteuerten Komparatoren werden während des Taktsignals P1 in ihrem semi-stabilen Zustand gehalten und bei abfallender Taktimpulsflanke des Taktsignals P1 aktiviert. Die Ausgabe des A/D-Wandlers erfolgt bei der steigenden Taktimpulsflanke des Taktsignals P2. Die Rückkopplungsschleife zum ersten A/D-Wandler umfasst das DEM Steuermodul Module als auch 2 Verzögerungselemente, wodurch das zurückgeführte Signal von der Erfassung durch den Quantisierer bis zur Einbringung der zurückgeführten Ladung am ersten Integrator eine Verzögerung von 2 Taktperioden erfährt. siehe Bezugszeichen 23, 25 und 27 in Fig. 3.

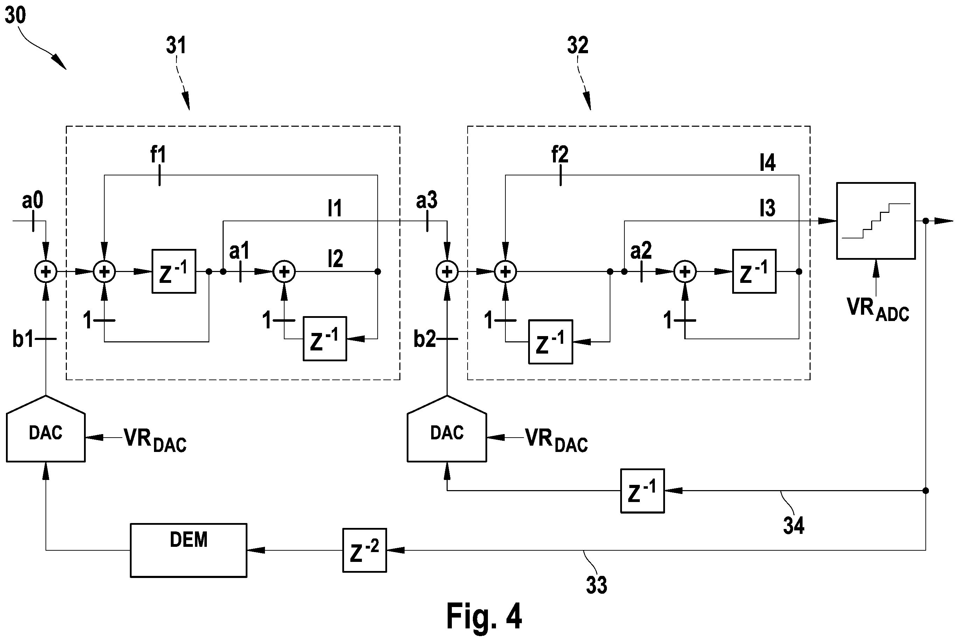

Das Blockdiagramm des BPSDM 30 in zeitdiskreter Darstellung ist in Figur 4 dargestellt. Der Schwingkreis S1, 31 ist aus zwei Integratoren I1 und 12 aufgebaut, wobei der erste Integrator I1 mit Einheitsverzögerung von $z^{-1}$ gestaltet wurde. Für den zweiten Integrator 12 ist eine Integrationsstufe mit Nullverzögerung erforderlich. Der zweite Schwingkreis S2, 32 besteht aus dem Integrator 13 mit Nullverzögerung gefolgt von dem Integrator 14 mit Einheitsverzögerung von $z^{-1}$. Die erste Rückkopplungsschleife 33 weist eine Verzögerung von $z^{-2}$ und die zweite Rückkopplungsschleife 34 eine Verzögerung von $z^{-1}$ auf. Die zweite Rückkopplungsschleife 34 dient der Stabilisierung des Systems.

Es ist bei der Erfindung vorteilhaft, wenn die Resonanzfrequenzen der SC-Schwingkreise ausreichend unempfindlich auf Prozessschwankungen sind, so dass eine Fertigung ohne Abgleich ermöglicht wird. Dazu ist es zweckmäßig, wenn die Verstärkungskoeffizienten, welche die Resonanzfrequenz mit Bezug auf die quarzgenaue Abtastfrequenz bestimmen, mit großer Genauigkeit gefertigt werden können. Aus Figur 2 ist ersichtlich, dass die Verstärkungskoeffizienten der SC-Schaltung durch Kapazitätsverhältnisse bestimmt werden. Um eine möglichst kleine Produktionsbedingte Streuung der Verstärkungskoeffizienten zu erreichen, werden die gepaarten Kapazitäten aus Parallelgeschalteten Einheitskapazitäten gebildet. Dadurch wird die Wahl der Verstärkungskoeffizienten jedoch auf rationale Verhältnisse eingeschränkt.

Die Resonanzfrequenz der SC-Schwingkreise lässt sich aus deren Signal Übertragungsfunktion bestimmen. Mit Bezug auf Figur 4 lässt sich die Signal-Übertragungsfunktion der beiden SC-Schwingkreise bestimmen zu:

$$TR1 = \frac{1-z}{z^2 - (a1 \cdot f1 + 2) \cdot z + 1} \qquad TR2 = \frac{z \cdot (1-z)}{z^2 - (a2 \cdot f2 + 2) \cdot z + 1}$$

Aus den Übertragungsfunktionen der SC-Schwingkreise erkennt man, dass deren Resonanzfrequenzen durch die Produkte der Koeffizienten a1*f1, beziehungsweise von a2*f2, bestimmt werden. Für die nominelle Abtastfrequenz von $f_s$ = 37.050MHz und die nominelle Zwischenfrequenz von ZF = 10.700MHz ergeben sich folgende Werte:

$$a1 \cdot f1 = a2 \cdot f2 = -2 + 2 \cdot \cos\left(2 \cdot \pi \cdot \frac{IF}{f_S}\right) = -2.483275$$

Für die Verstärkungskoeffizienten wurden folgende rationale Werte gewählt:

$$a1 = a2 = 31/20$$

$$f1 = f2 = -8/5$$

daher:

$$a1*f1 = a2*f2 = 2.480$$

dieser Wert liegt um 0.13% unter dem Zielwert. Die daraus resultierende Frequenzabweichung beträgt lediglich 8.3kHz.

Die Kapazitäten der Kondensatoren der SC-Schaltung wurden in Tabelle 1 zusammengestellt. In der symmetrischen Schaltungsausführung ist jeder aufgeführte Kondensator im positiven als auch im negativen Signalpfad vorhanden. Die Kapazitätswerte wurden Aufgrund der thermischen Rauschanforderungen bestimmt.

Tabelle 1: Zusammenstellung der Kapazitäten

| Kondensator | No. Units | C/Unit [fF] | Total [pF] |
|---|---|---|---|
| CSH | 8 | 140 | 1.12 |
| C1 | 40 | 140 | 5.60 |
| C2 | 20 | 280 | 5.60 |
| C12 | 31 | 280 | 8.68 |
| C21 | 64 | 140 | 8.96 |
| C13 | 6 | 140 | 0.84 |
| CDAC1 | 16 | 70 | 1.12 |
| C3 | 10 | 140 | 1.40 |
| C4 | 20 | 70 | 1.40 |
| C34 | 31 | 70 | 2.17 |
| C43 | 16 | 140 | 2.24 |
| CDAC2 | 16 | 70 | 1.12 |

Die rationalen Verstärkungskoeffizienten werden durch Kapazitätsverhältnisse bestimmt und sind aus Tabelle 2 ersichtlich.

Tabelle 2: Zusammenstellung der Verstärkungskoeffizienten des BPSDM

| K | A0 | a1 | a2 | a3 | b1 | b2 | f1 | f2 |
|---|---|---|---|---|---|---|---|---|
| Ratio | $C_{SH}/C_1$ | $C_{12}/C_2$ | $C_{34}/C_4$ | $C_{13}/C_3$ | $C_{DAC}/C_1$ | $-C_{DAC}/C_3$ | $-C_{21}/C_1$ | $-C_{43}/C_3$ |
| Value | 1/5 | 31/20 | 31/20 | 3/5 | 2/5 | -4/5 | -8/5 | -8/5 |

Die durch das Herstellungsverfahren bedingte Toleranz der Kapazitätsverhältnisse wurde aufgrund eines normalisierten Paarungsfehlers von ( C/C) = 0.04pF/pF berechnet, die sich auf gepaarte Einheitskapazitäten von 1pF bezieht. Die relativen Fehler der Verstärkungsprodukte a1*f1, beziehungsweise von a2*f2, betragen für eine Streubreite von 6 :

$$\varepsilon_{\alpha 1} = \frac{6*\sigma_{(a1*f1)}}{(a1*f1)} +1 = 1+/- 0.091\% \qquad \varepsilon_{\alpha 2} = \frac{6*\sigma_{(a2*f2)}}{(a2*f2)} +1 = 1+/- 0.182\%$$

Daraus ergeben sich folgende Frequenzfehler:

$$\Delta f_{6\sigma}(R1) = 7kHz \qquad \Delta f_{6\sigma}(R2) = 14kHz$$

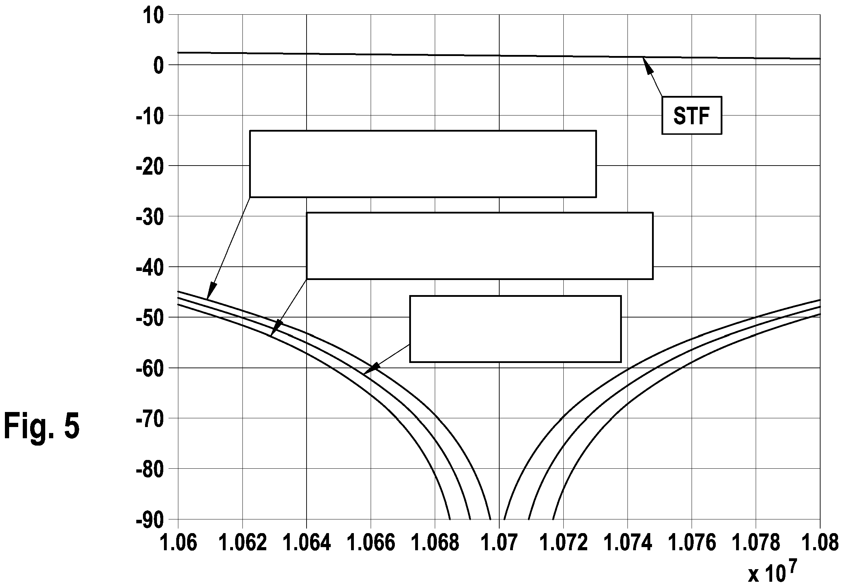

Die Signal- und Rausch-Übertragungsfunktionen (STF und NTF) sind in Figur 5 dargestellt.
Das Verhältnis zwischen dem maximalen Nutzsignal zum Quantisierungsrauschen (SQNR) wird weitgehend von der NTF bestimmt und wird daher auch von der Verstimmung der Schwingkreise beeinträchtigt. Die Beeinträchtigung des SQNR durch die Verstimmung der Schwingkreise wurde mittels eines zeitdiskreten Verhaltensmodells für eine Bandbreite von 300kHz (FM Betrieb), als auch von 9kHz (AM Betrieb) bestimmt; siehe Tabelle 3.

Tabelle 3: SQNR für FM und AM Betrieb

| Simulationsbedingung | B=300kHz (FM) | B=9kHz (AM) | SQNR |
|---|---|---|---|
| Nominelle Schwingkreise | 93.6 | 150.2 | dB |
| Beide Schwingkreise mit positiver Frequenzablage | 93.0 | 139.6 | dB |

(fortgesetzt)

| Simulationsbedingung | B=300kHz (FM) | B=9kHz (AM) | SQNR |
|---|---|---|---|
| Beide Schwingkreise mit negativer Frequenzablage | 93.5 | 150 | dB |

Anforderungsgemäss wurde der BPSDM für einen Dynamikbereich von 82dB bei einer Signal-Bandbreite von 300kHz dimensioniert. Dementsprechend muss ein Rauschspannungsabstand (SNR) von 82dB erreicht werden. Als Rauschquellen sind in erster Linie sämtliche thermische Rauschquellen zu nennen, die über dem Nutzfrequenzband als gleichmässig verteiltes Rauschen erscheinen. Die thermische Rauschenergie wird in erster Linie durch die Dimensionierung der Kondensatoren bestimmt und verhält sich umgekehrt proportional zu deren Kapazitäten (kT/C Rauschen). Die Verstärker der SC-Schaltung muss den gewählten Kapazitätswerten angepasst werden. Es ist also grundsätzlich möglich, das thermische Rauschen durch vergrössern der Kapazitätswerte zu reduzieren. Dabei sind jedoch die Verstärker entsprechend zu skalieren wobei deren Verlustleistung proportional ansteigt. Um diese Nachteile möglichst klein zu halten wurde die Schaltung derart optimiert, dass die thermische Rauschspannung marginal unter dem geforderten Wert bei -83dB unter dem maximalen Signalpegel zu liegen kommt und daher die Dominante Rauschquelle ist. Mit dem erreichten SQNR >=93dB wurde dieses angestrebte Ziel erreicht und verringert den Rauschspannungsabstand lediglich um ca. 0.5dB.

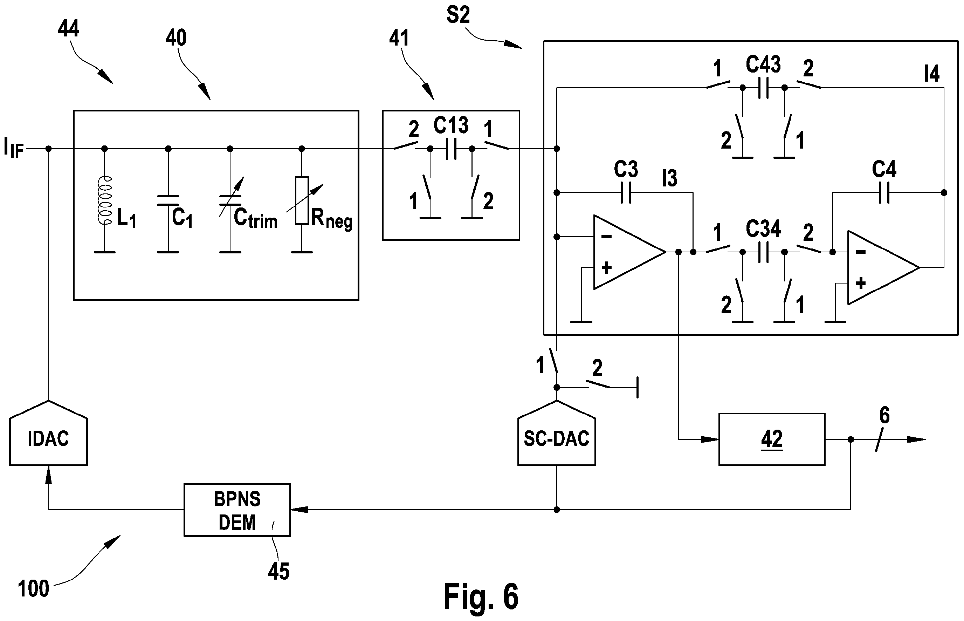

Als Alternative zum allgemeinen Aufbau des in Figur 2 dargestellten BPSDM wurde gemäss Figur 6 der erste Schwingkreis S1 durch einen passiven LC Schwingkreis 40 ersetzt, der im Wesentlichen aus den externen Bauelementen L1 und C1, sowie aus dem integrierten variablen Kondensator $C_{trim}$, und dem optionalen negativen Widerstandselement $R_{neg}$ besteht. Dadurch wird sowohl die Verlustleistung als auch der Flächenbedarf des integrierten Wandlers wesentlich reduziert. Zwar resultiert aus einer solchen Bauweise mit externem LC-Schwingkreis aufgrund seiner geringeren Kreisgüte eine Erhöhung des Quantisierungsrauschens.

Die Produktionsstreuung von kostengünstigen externen LC Bauelementen verursacht eine unzulässig große Streuung der Resonanzfrequenz des ersten Schwingkreises. Um dem entgegenzuwirken wurde ein algorithmischer Frequenzabgleich vorgesehen, der den Schwingkreis 40 mittels des variablen Kondensators $C_{trim}$ abgleicht. Der variable Kondensator besteht aus einem Feld von geschalteten Kondensatoren, die sich je nach Bedarf stufenweise zuschalten lassen. Als Alternative lässt sich der variable Kondensator auch aus binär gewichteten, geschalteten Kondensatoren aufbauen. Da sowohl die Kreisgüte als auch die Linearität des LC-Schwingkreises durch die im Frequenzabgleichsnetzwerk enthaltenen Schalter beeinträchtigt wird, ist es von Vorteil, für den LC-Resonanzkreis Bauelemente mit engen Toleranzen zu verwenden, um den erforderliche Frequenzabgleichsbereich einzuengen.

Zum Frequenzabgleich wird der LC-Schwingkreis mittels eines differentiellen Transkonduktanz-Verstärkers zur Eigenschwingung angeregt. Dieser Verstärker wurde in Fig. 6 symbolisch als negativer Widerstand ($R_{neg}$) dargestellt. Die Frequenzmessung erfolgt über hinreichend bekannte Frequenzzähler, welche die Resonanzfrequenz des LC-Schwingkreises über ein quarzgenaues Messfenster bestimmen.

Der in Figur 6 enthaltene zweite SC Schwingkreis S2 entspricht dem in Fig. 2 dargestellten Aufbau. Die Verbindung zwischen dem LC-Resonanzkreis und dem zweiten Resonator S2 erfolgt über eine passive "Track and Hold" - Schaltung 41 mittels dem schaltbaren Kondensator C13.

Durch die geringere Kreisgüte des LC Schwingkreises im Vergleich zum SC Schwingkreis erhöht sich das Quantisierungsrauschen im Nutzband um mehrere dB. Dieser Nachteil wurde durch höhere Auflösung des Quantisierers 42 und der D/A Umsetzer auf insgesamt 33 Stufen ausgeräumt.

Der Quantisierer 42 wird von Integrator 13 angesteuert. Die erste Rückkopplung mittels D/A Wandler zum LC-Resonanzkreises 44 erfolgt über das DEM Steuermodul 45, womit durch Dynamische Element-Paarung (DEM) mit Bandpass-Rauschformung zweiter oder höherer Ordnung das durch Paarungsfehler im D/A Wandler 16 verursachte Quantisierungsrauschen verringert werden. Zudem wird durch diese Maßnahme auch die erzielte Linearität des D/A Umsetzers verbessert. Die Linearitätsverbesserung ist besonders vorteilhaft, da der D/A Umsetzer zum LC-Schwingkreis aus geschalteten Stromquellen (I-DAC) gebildet wird, die aufgrund größerer Paarungsfehler der geschalteten Stromquellen im Vergleich zum SC-D/A Umsetzer größere Linearitätsfehler aufweisen. Die zweite Signalrückführung zum zweiten Schwingkreis S2 erfolgt mittels eines SC-DACs. Auf die Linearitätsverbesserung mittels dem DEM Steuerelement kann und dieser Stelle wiederum verzichtet werden.

Der Übergang zwischen zeitkontinuierlichem und zeitdiskretem Signal erfolgt durch das Abtast- und Halteglied das in dieser Anordnung dem LC-Schwingkreis 44 nachgeschaltet ist. Dadurch werden die Frequenzbänder, welche durch die Signalabtastung ins Nutzband gefaltet werden, durch den LC-Schwingkreis unterdrückt. Die tiefste Frequenz, welche ins Nutzband gefaltet wird, liegt bei der gewählten Abtastfrequenz von 37.05MHz bei 26.35MHz. Der Grad der Unterdrückung durch den LC Schwingkreis 44 ist stark abhängig von dessen Gütefaktor und beträgt 27dB für eine angenommene Kreisgüte von Q = 30.

Die Linearität des Wandlers ist im Wesentlichen durch die erste Stufe bestehend aus dem LC-Resonanzkreises 44 und dem D/A Umsetzer (IDAC) bestimmt. Da die Linearität des LC-Resonanzkreises 44 durch das Verhältnis zwischen nichtlinearen zu linearen Kapazitäten des LC-Resonanzkreises 44 bestimmt wird, wird für die Kapazität $C_1$ ein relativ hoher Wert von 280pF mit einer Abweichung von +/- 2% vorgeschlagen. Daraus resultiert eine Induktivität von 1.5uH. Es können erfindungsgemäß jedoch auch andere Werte für die Kapazität und die Induktivität gewählt werden.

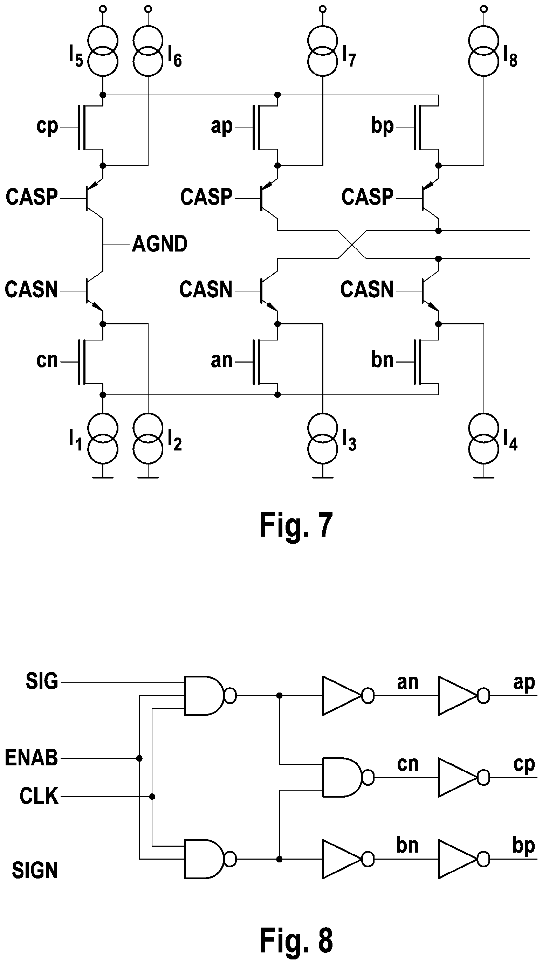

Das in Figur 7 dargestellte D/A-Wandler Modul wird im Wesentlichen aus zwei komplementären Dreiweg Stromschaltern gebildet. Dabei wird der Strom der Senke $I_1$ mittels der NMOS Transistoren über die zugeordneten NPN Transistoren entweder an den positiven Ausgang "OutP", oder and den negativen Ausgang "OutN" geschaltet, oder aber an keinen der beiden Ausgänge. Im letzteren Fall wird der Strom über die dritte Schalterstellung an die analoge Masse "AGND" weitergeleitet. Der komplementäre zweite Dreiwegschalter wird durch die drei PMOS Transistoren und die zugeordneten PNP Transistoren gebildet. Die Stromsenken $I_2$ bis $I_4$ und die Stromquellen $I_6$ bis $I_8$ dienen zur Durchströmung der NPN, beziehungsweise der PNP Kaskaden-Transistoren im ausgeschalteten Zustand, wodurch schneller Einschaltzeiten erreicht werden.

Die Steuerlogik zum I-DAC Element ist in Figur 8 dargestellt. Dabei wird das I-DAC Element mit RZ-Kodierung (return-to-zero) angesteuert. Diese Schaltung gibt den Stromausgang jedes I-DAC Elements nur bei positivem Takt "CLK" frei, sofern der Ausgangsstrom durch das Freischaltsignal "ENAB" angesteuert wurde. Abhängig von Vorzeichen-Steuersignal "SIG", beziehungsweise dem komplementären Steuersignal "SIGN" wird die Stromrichtung an den Ausgängen "OutP" und "OutN" jedes einzelnen I-DAC Elements bestimmt. Die Steuersignale ENAB, SIG, und SIGN werden jeweils bei negativem Taktsignal umgeschaltet.

Die alternative NRZ-Kodierung (non-return-to-zero) ist grundsätzlich auch möglich und könnte zur Entspannung an die hohen Anforderungen und den Takt-Jitter genutzt werden.

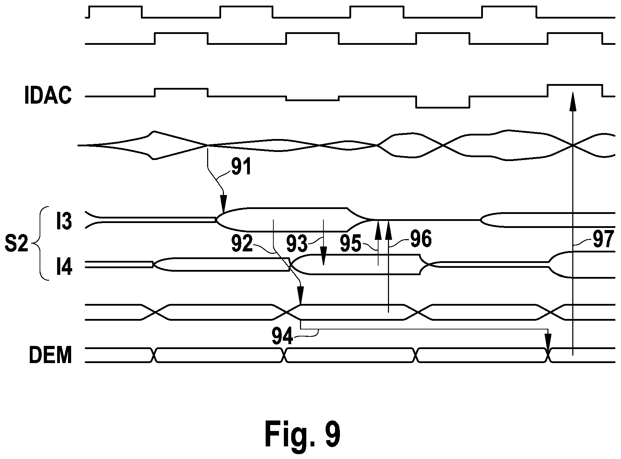

Der zeitliche Ablauf des BPSDM mit LC-Schwingkreis ist in Figur 9 gezeigt. Während das Taktsignal P2 hoch ist, befindet sich das Abtast- und Halteglied im Abtast-Modus und lädt, unter Bezugnahme auf Figur 2, den Kondensator CSH des Abtast- und Halteglieds 13 auf den momentanwert des LC-Schwingkreises. Bei abfallender Taktimpulsflanke von P2 wird der Kondensators CSH vom Eingang getrennt und behält seine Ladung, die der Spannung über CSH im Moment der Abtastung entspricht. Die abgetastete Ladung wird dann während des folgenden Taktsignals P1 gemäß Bezugszeichen 91 in Figur 9 an den Integrator 13 des übertragen. Die weiteren Ladungsübertragungen 92 bis 97 sind ebenfalls in Fig. 9 dargestellt. Dabei ist zu beachten, dass das Rückführungssignal zum I-DAC im DEM Steuermodul analog zu Fig. 4 um 2 Taktperioden verzögert wird. Der I-DAC wird jeweils während dem Takt P2 frei geschaltet. Die in Fig. 9 dargestellten Spannungsverläufe des LC-Schwingkreises, des Abtast- und Halteglieds, sowie der Integratoren 13 und 14 veranschaulichen die Spannungsverläufe an deren komplementären Ausgängen.

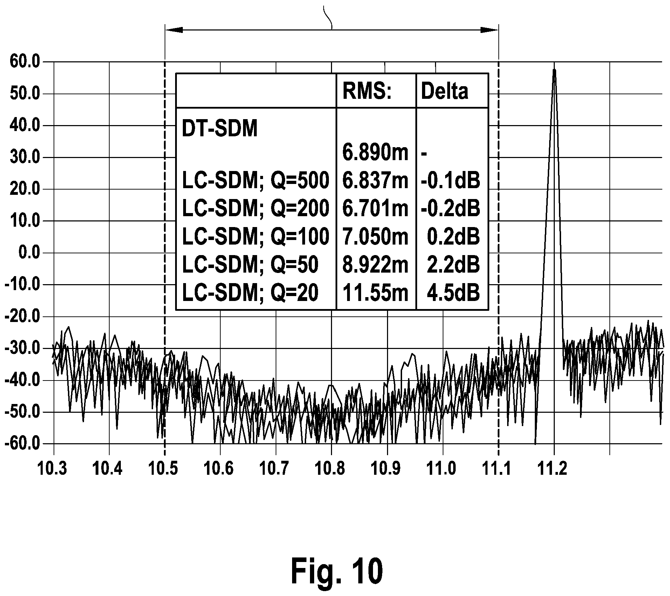

Das Quantisierungsrauschen des BPSDM gemäß Fig. 10 wurde mittels Schaltungssimulation für verschiedene Gütefaktoren des LC Schwingkreises bestimmt und mit dem Quantisierungsrauschen eines zeitdiskreten Referenzwandlers verglichen, wie es in Fig. 10 ersichtlich ist. Für sehr hohe, Kreisgüten von Q>500 entspricht das simulierte Quantisierungsrauschen sehr gut dem des Referenzwandlers; solche hohen Kreisgüten sind jedoch nicht praxisgerecht. Das Quantisierungsrauschen erhöht sich für niedrigere Gütefaktoren. Für einen realistischen Gütefaktor von Q>=30, der ohne Erhöhung des Q-Werts durch ein negatives Impedanznetzwerk erreichbar ist, erhöht sich das Quantisierungsrauschen um ungefähr 3,5dB. Das Verhältnis des Signals zum Quantisierungsrauschen wurde mit 17 Quantisierungsstufen für eine Kreisgüte von Q=30 zu 86,5dB bestimmt. Um die Verringerung des Quantisierungsrauschabstandes auszugleichen, wurde die Auflösung des Quantisierers sowie der D/A Umsetzer von 17 Stufen auf 33 Stufen erhöht, womit der Quantisierungsrauschabstand um 6dB auf 92,5dB erhöht wurde.

Alternativ dazu kann ein negatives Impedanz-Netzwerk eingesetzt werden, um den Gütefaktor des LC-Resonanzkreises 10 zu erhöhen, was jedoch negative Einflüsse auf das thermische Rauschen und die Verlustleistung nach sich zieht. Dazu kann der Transkonduktanz-Verstärker genutzt werden, der bereits zur Frequenzmessung des LC-Schwingkreises erwähnt wurde. Um eine optimale Kreisgüte zu erreichen ist jedoch ein Abgleich der negativen Widerstandswertes erforderlich. Beim Anheben der Kreisgüte mittels dem Transkonduktanz-Verstärker ist die Reduktion des Quantisierungsrauschens dem Anwachsen des thermischen Rauschens gegenüberzustellen und ist nicht generell vorteilhaft.

**Patentansprüche**

1. Bandpass-Sigma-Delta-Analog-Digital-Wandler (1) mit in Kaskaden geschaltetem ersten und zweiten Bandpass-Filter (2,3), mit einem ersten und einem zweiten D/A-Umsetzer (5,6) und mit einem Dynamic-Element-Matching Steuermodul (7) und mit einem Quantisierer (4) mit Rückkopplung mittels eines D/A-Umsetzers zum ersten und zum zweiten Filter (2,3), wobei die Rückkopplung an das erste Filter (2) über das Dynamic-Element-Matching Steuermodul (7) durch Bandpass-Rauschformung zweiter Ordnung zum ersten D/A-Umsetzer (5) geführt wird, und die Rückkopplung an das zweite Filter (3) jedoch nicht über das Dynamic-Element-Matching Steuermodul (7) erfolgt.

**2.** Bandpass-Sigma-Delta-Analog-Digital-Wandler nach Anspruch 1, **dadurch gekennzeichnet, dass** der erste und der zweite Bandpass-Filter mit geschalteten Kapazitäten implementiert sind, so dass das Quantisierungsrauschen bei einer bevorzugten Abtastfrequenz von insbesondere 37.05MHz für die bevorzugte Zwischenfrequenz (ZF) von 10,700 MHz ein Minimum aufweist.

**3.** Bandpass-Sigma-Delta-Analog-Digital-Wandler nach Anspruch 2, **dadurch gekennzeichnet, dass** die Frequenz des Rauschminimum im Wesentlichen durch ganzzahlige Kapazitätsverhältnisse bestimmt wird.

**4.** Bandpass-Sigma-Delta-Analog-Digital-Wandler nach Anspruch 3, **dadurch gekennzeichnet, dass** durch die Bestimmung der Frequenz des Rauschminimums ein Frequenzabgleich hinfällig wird.

**5.** Bandpass-Sigma-Delta-Analog-Digital-Wandler nach einem der vorangehenden Ansprüche, **dadurch gekennzeichnet, dass** das erste Bandpass-Filter durch einen LC-Schwingkreis mit integriertem Frequenzabgleich gebildet ist und das zweite Bandpass-Filter mit geschalteten Kapazitäten implementiert ist.

**6.** Bandpass-Sigma-Delta-Analog-Digital-Wandler nach einem der vorangehenden Ansprüche **dadurch gekennzeichnet, dass** mittels einer Verstärkerschaltung ein variabler negativer Widerstand parallel zum LC-Schwingkreis vorgesehen wird, der den LC-Schwingkreis zum Frequenzabgleich zum Schwingen anregt.

**7.** Bandpass-Sigma-Delta-Analog-Digital-Wandler nach Anspruch 6, **dadurch gekennzeichnet**, der Widerstand weiterhin zur Anhebung der Kreisgüte des LC-Schwingkreis verwendbar ist.

**Claims**

**1.** Bandpass sigma-delta analogue-to-digital converter (1) having first and second bandpass filters (2, 3) connected in cascades, having a first and a second D/A converter (5, 6) and having a dynamic element matching control module (7) and having a quantizer (4) with feedback by means of a D/A converter to the first and the second filter (2, 3), wherein the feedback to the first filter (2) is routed to the first D/A converter (5) via the dynamic element matching control module (7) by second-order bandpass noise shaping, and the feedback to the second filter (3) is not effected via the dynamic element matching control module (7), however.

**2.** Bandpass sigma-delta analogue-to-digital converter according to Claim 1, **characterized in that** the first and second bandpass filters are implemented with switched capacitances, so that the quantization noise at a preferred sampling frequency of particularly 37.05 MHz is at a minimum for the preferred intermediate frequency (IF) of 10.700 MHz.

**3.** Bandpass sigma-delta analogue-to-digital converter according to Claim 2, **characterized in that** the frequency of the noise minimum is determined essentially by integer capacitance ratios.

**4.** Bandpass sigma-delta analogue-to-digital converter according to Claim 3, **characterized in that** the determination of the frequency of the noise minimum renders frequency matching invalid.

**5.** Bandpass sigma-delta analogue-to-digital converter according to one of the preceding claims, **characterized in that** the first bandpass filter is formed by an LC resonant circuit with integrated frequency matching and the second bandpass filter is implemented with switched capacitances.

**6.** Bandpass sigma-delta analogue-to-digital converter according to one of the preceding claims, **characterized in that** an amplifier circuit is used to provide a variable negative resistance in parallel with the LC resonant circuit, which prompts the LC resonant circuit to oscillate for the purpose of frequency matching.

**7.** Bandpass sigma-delta analogue-to-digital converter according to Claim 6, **characterized in that** the resistance can moreover be used to raise the Q factor of the LC resonant circuit.

**Revendications**

**1.** Convertisseur analogique/numérique Sigma Delta passe-bande (1), comprenant des premier et deuxième filtres passe-bande (2, 3) branchés en cascade, comprenant un premier et un deuxième convertisseur N/A (5, 6) et comprenant un module de commande d'adaptation d'élément dynamique (7) et comprenant un quantificateur (4) avec rétroaction au moyen d'un convertisseur N/A vers le premier et le deuxième filtre (2, 3), la rétroaction au niveau du premier filtre (2) étant menée vers le premier convertisseur N/A (5) par le biais du module de commande d'adaptation d'élément dynamique (7) par formation de bruit à large de bande de deuxième ordre, et la rétroaction au niveau du deuxième filtre (3) ne s'effectuant cependant pas par le biais du module de commande d'adaptation d'élément dynamique (7).

2. Convertisseur analogique/numérique Sigma Delta passe-bande selon la revendication 1, **caractérisé en ce que** le premier et le deuxième filtre passe-bande sont mis en oeuvre avec des capacités commutées, de sorte que les bruits de quantification présentent un minimum avec une fréquence d'échantillonnage préférée notamment de 37,05 MHz pour la fréquence intermédiaire (FI) préférée de 10,700 MHz.

3. Convertisseur analogique/numérique Sigma Delta passe-bande selon la revendication 2, **caractérisé en ce que** la fréquence du minimum de bruit est pour l'essentiel déterminée par des rapports de capacité entiers.

4. Convertisseur analogique/numérique Sigma Delta passe-bande selon la revendication 3, **caractérisé en ce qu'**un alignement des fréquences devient caduc de par la détermination de la fréquence du minimum de bruit.

5. Convertisseur analogique/numérique Sigma Delta passe-bande selon l'une des revendications précédentes, **caractérisé en ce que** le premier filtre passe-bande est formé par un circuit oscillant LC avec alignement des fréquences intégré et le deuxième filtre passe-bande est mis en oeuvre avec des capacités commutées.

6. Convertisseur analogique/numérique Sigma Delta passe-bande selon l'une des revendications précédentes, **caractérisé en ce qu'**une résistance négative variable est prévue parallèlement au circuit oscillant LC au moyen d'un circuit amplificateur, laquelle excite le circuit oscillant LC en oscillant en vue de l'alignement des fréquences.

7. Convertisseur analogique/numérique Sigma Delta passe-bande selon la revendication 6, **caractérisé en ce que** la résistance peut en outre être utilisée pour relever le coefficient de qualité du circuit oscillant LC.

Fig. 1

Fig. 2

**Fig. 3**

EP 2 102 987 B1

Fig. 4

Fig. 5

Fig. 6

Fig. 7

Fig. 8

**Fig. 9**

EP 2 102 987 B1

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5442353 A
- US 20050134492 A1
- GB 2364188 A
- WO 0001074 A